# EUROPEAN PATENT APPLICATION

(11) **EP 4 531 119 A1**
(43) Date of publication of application: **02.04.2025**
(21) Application number: 24187740.6
(22) Date of filing: 10.07.2024
(51) Int. Cl.: H01L 33/14, H01L 33/02

(54) **LIGHT EMITTING DIODE**

(30) Priority: 29.09.2023 TW 112137594
(71) Applicant: Taiwan-Asia Semiconductor Corporation, Hsinchu City 30078 (TW)
(72) Inventor: Yu-Ling, Cheng, Hsinchu City 30078 (TW); Hsieh, Po-Jen, Hsinchu City 30078 (TW); Wang, Tzu-Wen, Hsinchu City 30078 (TW); Lin, Yi-Jen, Hsinchu City 30078 (TW)
(74) Representative: Michalski Hüttermann & Partner Patentanwälte mbB

(57) **Abstract**

The invention relates to a light emitting diode, which comprises a substrate and a semiconductor epitaxy structure. The semiconductor epitaxial structure is disposed on the substrate. The semiconductor epitaxial structure comprises semiconductor composite layers and a plurality of current spreading layers which are disposed among the semiconductor composite layers. The doping concentrations of the upper and lower adjacent current spreading layers are alternately high and low.

## Description

### CROSS-REFERENCES TO RELATED APPLICATIONS

This application claims the benefit of priority to Taiwanese Patent Application No. 112137594 filed on September 29, 2023, which is hereby incorporated by reference in its entirety.

### BACKGROUND OF THE INVENTION

### Field of the Invention

The present invention relates to a light emitting diode, and in particular to a light emitting diode with uniform current spreading.

### Descriptions of the Related Art

The light emitting diodes (LEDs) in solid-state lighting devices are characterized by low power consumption, low heat generation, long lifespan, durability, compact size, short response time, and excellent optoelectronic properties, such as stable emission wavelengths. Consequently, they have been widely applied in household appliances, indicator lights, and optoelectronic products. With the advancement of optoelectronic technology, solid-state lighting devices have made significant progress in terms of luminous efficiency, operational lifespan, and brightness. LEDs have emerged as the mainstream for future lighting fixtures.

The working principle of LEDs involves applying voltage between two different types of semiconductor materials, guiding electrons and holes into the P-N junction region. Current spreading allows these charge carriers to move from high concentration areas to low concentration areas, achieving effective carrier injection. When electrons and holes are injected into the P-N junction region, they undergo recombination within this region to release energy and generate the light emitted by the LEDs. Current spreading ensures that a large number of electrons and holes can meet in the emissive region for increasing the chances of carrier recombination and thereby enhancing the luminous efficiency. If the carrier density is not uniform enough, only certain regions will emit light and lead to uneven illumination and color variation.

To overcome the above-mentioned issues, the industry urgently needs an innovative LED structure to address the problem of poor current spreading in order to enhance the brightness of the LEDs.

### SUMMARY OF THE INVENTION

The main objective of the present invention is to provide an innovative LED structure to address issues such as decreased luminous efficiency, uneven illumination, and color variation caused by uneven current distribution in conventional LED devices. The goal is to enhance the brightness of the light emitting diode.

To achieve the above objective, the present invention discloses a light emitting diode which comprises a substrate and a semiconductor epitaxy structure. The semiconductor epitaxial structure is disposed on the substrate. The semiconductor epitaxial structure comprises a semiconductor composite layer and a plurality of current spreading layers which are disposed among the semiconductor composite layers. The doping concentrations of the upper and lower adjacent current spreading layers are alternately high and low.

In one embodiment of the light emitting diode of the present invention, wherein the materials of each of the current spreading layers are selected from a group consisting of indium gallium phosphide (InGaP), aluminum gallium indium phosphide (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), gallium arsenide (GaAs), gallium arsenide phosphide (GaAsP), and indium gallium arsenide phosphide (InGaAsP).

In one embodiment of the light emitting diode of the present invention, wherein the doping material of each of the current spreading layers comprises silicon (Si) or tellurium (Te).

In one embodiment of the light emitting diode of the present invention, wherein the high doping concentration of the upper and lower adjacent current spreading layers is approximately 0.9~3.5E18/cm³, and the low doping concentration of the upper and lower adjacent current spreading layers is approximately 0.9~3.5E17/cm³.

In one embodiment of the light emitting diode of the present invention, wherein the thickness of the lower current spreading layer among the current spreading layers is greater than that of the upper adjacent current spreading layer.

In one embodiment of the light emitting diode of the present invention, wherein the thickness of each of the current spreading layers is given by b+a×(N-1), where N is the total number of the current spreading layers, N is a positive integer between 1 and 1000, b is the thickness of the first layer of the current spreading layers, 0<b<10 micrometers, and a is the increment in thickness for each of the current spreading layers, and 0<a<10 micrometers.

To achieve the above objective, the present invention discloses a light emitting diode which comprises a substrate and a semiconductor epitaxy structure. The semiconductor epitaxial structure is disposed on the substrate. The semiconductor epitaxial structure comprises a semiconductor composite layer and a plurality of current spreading layers which are disposed among the semiconductor composite layers. The thickness of the lower current spreading layer is greater than that of the upper adjacent current spreading layer.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is a schematic diagram illustrating the structure of a light emitting diode in one embodiment of the present invention;
FIG. 2 is a schematic diagram illustrating the structure of the light emitting diode in one embodiment of the present invention; and
FIG. 3 is a partial enlarged schematic diagram illustrating the light emitting diode in one embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

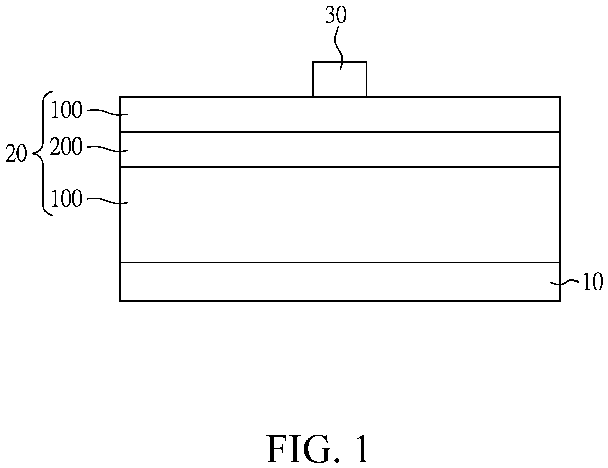

Please refer to the schematic diagram of the LED structure in one embodiment of the present invention as shown in FIG. 1. In this embodiment, the light emitting diode comprises a substrate 10, a semiconductor epitaxy structure 20, and an electrode structure 30. The semiconductor epitaxy structure 20 is disposed on the substrate 10. In this embodiment of the present invention, the substrate 10 is a semiconductor substrate. Preferably, in the manufacturing process of the LED, wafer bonding is performed between a silicon substrate and the semiconductor epitaxy structure 20. The electrode structure 30 is disposed on the semiconductor epitaxy structure 20. Additionally, the semiconductor epitaxy structure 20 of the LED in the present invention includes a semiconductor composite layer 100 and a plurality of current spreading layers 200, each current spreading layer 200 being disposed within the semiconductor composite layer 100.

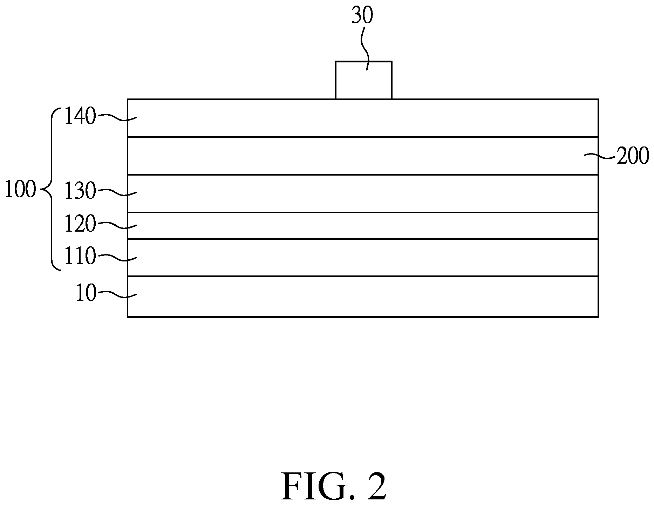

Please refer to both FIG. 1 and FIG. 2. FIG. 2 illustrates the structure of the light emitting diode in one embodiment of the present invention. The semiconductor composite layer 100 includes a P-type semiconductor layer 110, a light emitting layer 120, an N-type semiconductor lower layer 130, and an N-type semiconductor upper layer 140. Specifically, the P-type semiconductor layer 110 is disposed on the substrate 10, the light emitting layer 120 is disposed on the P-type semiconductor layer 110, the N-type semiconductor lower layer 130 is disposed on the light emitting layer 120, and the N-type semiconductor upper layer 140 is disposed on the current spreading layers 200. In a preferred embodiment of the present invention, the current spreading layers 200 are composed of homogenous semiconductor epitaxy stack structures with the same material proportions. Specifically, the material of the P-type semiconductor layer 110 can be aluminum gallium indium phosphide, aluminum indium phosphide, or gallium phosphide doped with magnesium or carbon. The material of the N-type semiconductor lower layer 130 and N-type semiconductor upper layer 140 can be aluminum gallium indium phosphide doped with silicon or tellurium, with a proportion of AlₓGa_{0.5-x}In_{0.5}P (x=0~0.5), and silicon or tellurium doping concentration of approximately 0.9~3.5E18/cm³. The thickness of each layer in the N-type semiconductor lower layer 130 and the N-type semiconductor upper layer 140 is approximately 0.05-5 micrometers. The light emitting layer 120 is a multiple quantum well (MQW) structure, and in this embodiment, the emission wavelength of the multiple quantum wells can be, but not limited to, the range of 600-700 nanometers. The current spreading structure disclosed in the present invention can be specifically applied to light emitting diodes in other emission wavelength ranges.

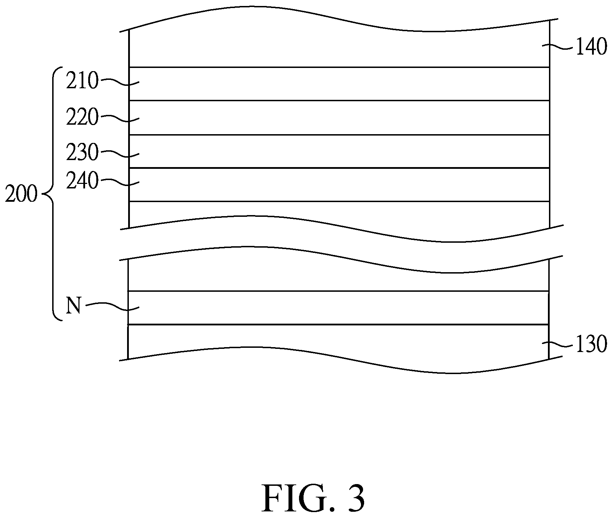

Please refer to FIG. 1, FIG. 2, and FIG. 3, where FIG. 3 shows a partial enlarged schematic view of the light emitting diode of the present invention. To improve the issues of current crowding and poor spreading in conventional light emitting diodes, a plurality of current spreading layers 200 are introduced between the N-type semiconductor lower layer 130 and N-type semiconductor upper layer 140 in the semiconductor epitaxy structure 20 of the present invention. The current spreading layers are designed to achieve uniform current spreading and thereby enhance the brightness of the light emitting diode. Specifically, to achieve the effect of current spreading, the current spreading layers 200 disposed between the N-type semiconductor lower and upper layers exhibit the characteristic of alternating high and low doping concentrations in the upper and lower adjacent current spreading layers. For example, the first current spreading layer 210 adjacent to the N-type semiconductor upper layer 140 is a low-doping concentration aluminum gallium indium phosphide epitaxial layer with a proportion of AlₓGa_{0.5-x}In_{0.5}P (x=0~0.5). The doping concentration of the first current spreading layer 210 is approximately 0.9~3.5E17/cm³ by using silicon or tellurium as doping elements. Below the first current spreading layer 210, the second current spreading layer 220, adjacent to it, is a high-doping concentration aluminum gallium indium phosphide epitaxial layer with the same proportion of AlₓGa_{0.5-x}In_{0.5}P (x=0~0.5). The doping concentration of the second current spreading layer 220 is approximately 0.9~3.5E18/cm³ by using silicon or tellurium as doping elements. Similarly, the third current spreading layer 230 and other odd-numbered layers have the same doping concentration as the first current spreading layer 210, belonging to low-doping concentration aluminum gallium indium phosphide epitaxial layers with a doping concentration of 0.9~3.5E17/cm³. The fourth current spreading layer 240 and other even-numbered layers have the same doping concentration as the second current spreading layer 220, belonging to high-doping concentration aluminum gallium indium phosphide epitaxial layers with a doping concentration of 0.9~3.5E18/cm³. In other embodiments, odd-numbered layers can be arranged as high-doping concentration layers, and even-numbered layers can be low-doping concentration layers, and so on. In practical applications, the number of current spreading layers 200 in the semiconductor epitaxy structure 20 of the light emitting diode of the present invention can be determined based on the actual effect of uniform current spreading. It should be noted that the low or high doping concentration of each layer in the current spreading layers mentioned above is just an example and is not limited thereto. The present invention does not impose restrictions on the doping elements and doping concentrations, and it is only necessary that the upper and lower adjacent two spreading layers have substantial resistance differences caused by differences in doping concentrations.

As mentioned above, when the doping concentration of the current spreading layer is low, the resistance value thereof is higher, and conversely, when the doping concentration of the current spreading layer is high, the resistance value thereof is lower. The current spreading layers 200 are arranged with alternating high and low doping concentrations in the adjacent upper and lower current spreading layers. This arrangement causes the current to strengthen laterally in the high-doping concentration layer with lower resistance. However, when the current flows downward and encounters the high resistance layer with low doping concentration, the longitudinal flow is hindered so that the current will be forced to spread laterally. Therefore, when the current is injected from the upper electrode 30 into the current spreading layers, the structure of alternating high and low doping concentrations between the layers results in a "longitudinal hindrance, lateral enhancement" spreading effect between the layers. This ensures effective and uniform current spreading before entering the light emitting layer 120.

The abovementioned AlGaInP current spreading layer is just one embodiment, and adjustments can be made based on the different epitaxy structures of the light emitting diode in practical applications. The materials for each current spreading layer can be selected from a group consisting of indium gallium phosphide (InGaP), aluminum gallium indium phosphide (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), gallium arsenide (GaAs), gallium arsenide phosphide (GaAsP), and indium gallium arsenide phosphide (InGaAsP).

Moreover, to achieve effective and uniform current spreading, in addition to the aforementioned technique of alternating high and low doping concentrations, the thickness of each of the current spreading layers 200 can also be adjusted to achieve the effect of uniform current spreading. Specifically, in the epitaxial stacking of each current spreading layer, the thickness of the lower current spreading layer in each pair of adjacent layers can be made greater than that of the upper adjacent current spreading layer. In other words, the current spreading layer 200 has the characteristics of "gradient thickness, denser above and sparser below". The thickness of each layer becomes thicker from top to bottom as it approaches the light emitting layer 120. By gradually increasing the thickness of the current spreading layers, the effective sheet resistance of each layer will also increase gradually. This compels the current to achieve an effective uniform current spreading of "longitudinal hindrance, lateral strengthening" as it is injected from top to bottom. It should be noted that the definition of "denser above and sparser below" in the present invention refers to the direction closer to the light emitting layer being "below," and conversely, the direction away from the light emitting layer being "above." The thickness of the current spreading layer closer to the light emitting layer is relatively greater, i.e., "sparser," while the thickness of the current spreading layer away from the light emitting layer is thinner, i.e., "denser." The principle of current spreading is that the layer with lower concentration and greater thickness has a higher resistance value, causing hindrance to the longitudinal flow of current. Conversely, a layer with a lower resistance value enhances lateral current flow within the layer. Closer to the light emitting layer, a stronger spreading effect is desired, so a higher weight must be assigned and result in a thicker thickness in the lower part closer to the light emitting layer.

Specifically, in practical applications, the thickness of the Nth layer in the current spreading layers can be set as b+a×(N-1). Here, N represents the total number of current spreading layers, and N can be any positive integer between 1 and 1000, but not limited to 1000. b is the thickness of the first current spreading layer 210, where 0<b<10 micrometers, but not limited to this range. a represents the increment in thickness for each of the current spreading layers, where 0<a<10 micrometers, but not limited to this range. Refer to the table 1 below, which specifically illustrates an embodiment of the present invention. In this example, when the total number of current spreading layers is 16, and the thickness b of the first current spreading layer 210, along with the increment in thickness a for each layer are specified, the table shows the gradual variation in thickness for each current spreading layer, with alternating high and low doping concentrations.

**Table 1**

| doping concentration (doping element : Si or Te) | index of layers | thickness of layers | proportion of AlGaInP |
|---|---|---|---|
| low doping | N=1 | b | AlₓGa_{0.5-x}In_{0.5}P |
| high doping | N=2 | b+a | AlₓGa_{0.5-x}In_{0.5}P |
| low doping | N=3 | b+2a | AlₓGa_{0.5-x}In_{0.5}P |
| high doping | N=4 | b+3a | AlₓGa_{0.5-x}In_{0.5}P |
| low doping | N=5 | b+4a | AlₓGa_{0.5-x}In_{0.5}P |
| high doping | N=6 | b+5a | AlₓGa_{0.5-x}In_{0.5}P |
| low doping | N=7 | b+6a | AlₓGa_{0.5-x}In_{0.5}P |
| high doping | N=8 | b+7a | AlₓGa_{0.5-x}In_{0.5}P |
| low doping | N=9 | b+8a | AlₓGa_{0.5-x}In_{0.5}P |
| high doping | N=10 | b+9a | AlₓGa_{0.5-x}In_{0.5}P |
| low doping | N=11 | b+10a | AlₓGa_{0.5-x}In_{0.5}P |
| high doping | N=12 | b+11a | AlₓGa_{0.5-x}In_{0.5}P |
| low doping | N=13 | b+12a | AlₓGa_{0.5-x}In_{0.5}P |
| high doping | N=14 | b+13a | AlₓGa_{0.5-x}In_{0.5}P |
| low doping | N=15 | b+14a | AlₓGa_{0.5-x}In_{0.5}P |
| high doping | N=16 | b+15a | AlₓGa_{0.5-x}In_{0.5}P |

In summary, the design principles of the current spreading structure adopted in the present invention are summarized as follows: 1. each current spreading layer containing dopants, with alternating high and low doping concentrations therein; 2. no strict limitation on the doping concentration, only a difference between high and low concentrations; 3. a method of gradual thickness variation being adopted without the need for the generation of piezoelectric field effects in the crystal lattice and a certain level of spreading effectiveness being achieved even if the thickness of each current spreading layer is excessively thick or thin; and 4. not necessary a conventional fixed thickness ratio superlattice alternation, only the epitaxy stacking layers in the current spreading layers with gradual thickness variation (denser above and sparser below) and/or alternating high and low doping concentrations.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A light emitting diode, comprising:
a substrate; and
a semiconductor epitaxy structure, disposed on the substrate, comprising
a semiconductor composite layer; and
a plurality of current spreading layers, disposed among the semiconductor composite layer, wherein the doping concentrations of the upper and lower adjacent current spreading layers are alternately high and low.

2. The light emitting diode of claim 1, wherein the materials of each of the current spreading layers are selected from a group consisting of indium gallium phosphide (InGaP), aluminum gallium indium phosphide (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), gallium arsenide (GaAs), gallium arsenide phosphide (GaAsP), and indium gallium arsenide phosphide (InGaAsP).

3. The light emitting diode of claim 2, wherein the doping material of each of the current spreading layers comprises silicon (Si) or tellurium (Te).

4. The light emitting diode of claim 3, wherein the high doping concentration of the upper and lower adjacent current spreading layers is approximately 0.9~3.5E18/cm³, and the low doping concentration of the upper and lower adjacent current spreading layers is approximately 0.9~3.5E17/cm³.

5. The light emitting diode of claim 1, wherein the thickness of the lower current spreading layer among the current spreading layers is greater than that of the upper adjacent current spreading layer.

6. The light emitting diode of claim 5, wherein the thickness of each of the current spreading layers is given by b+a×(N-1), where N is the total number of the current spreading layers, N is a positive integer between 1 and 1000, b is the thickness of the first layer of the current spreading layers, 0<b<10 micrometers, and a is the increment in thickness for each of the current spreading layers, and 0<a<10 micrometers.

7. A light emitting diode, comprising:
a substrate; and
a semiconductor epitaxy structure, disposed on the substrate, comprising
a semiconductor composite layer; and
a plurality of current spreading layers, disposed among the semiconductor composite layer, wherein the thickness of the lower current spreading layer is greater than that of the upper adjacent current spreading layer.

8. The light emitting diode of claim 7, wherein the thickness of each of the current spreading layers is given by b+a×(N-1), where N is the total number of the current spreading layers, N is a positive integer between 1 and 1000, b is the thickness of the first layer of the current spreading layers, 0<b<10 micrometers, and a is the increment in thickness for each of the current spreading layers, and 0<a<10 micrometers.

9. The light emitting diode of claim 7, wherein the materials of each of the current spreading layers are selected from a group consisting of indium gallium phosphide (InGaP), aluminum gallium indium phosphide (AlGaInP), aluminum indium phosphide (AlInP), indium gallium arsenide (InGaAs), aluminum indium gallium arsenide (AlInGaAs), aluminum gallium arsenide (AlGaAs), aluminum gallium arsenide phosphide (AlGaAsP), gallium arsenide (GaAs), gallium arsenide phosphide (GaAsP), and indium gallium arsenide phosphide (InGaAsP).

10. The light emitting diode of claim 7, wherein the doping concentrations of the upper and lower adjacent current spreading layers are alternately high and low.

11. The light emitting diode of claim 10, wherein the doping material of each of the current spreading layers comprises silicon (Si) or tellurium (Te).

12. The light emitting diode of claim 11, wherein the high doping concentration of the upper and lower adjacent current spreading layers is approximately 0.9~3.5E18/cm³, and the low doping concentration of the upper and lower adjacent current spreading layers is approximately 0.9~3.5E17/cm³.
